Europäisches Patentamt

European Patent Office

Office européen des brevets

(19)

(11) Publication number: **0 250 260 B1**

(12) **EUROPEAN PATENT SPECIFICATION**

(45) Date of publication of patent specification: **13.11.91**   (51) Int. Cl.5: **D02G 3/12**

(21) Application number: **87305468.8**

(22) Date of filing: **19.06.87**

(54) Use of a metal-containing conjugated yarn.

(30) Priority: **20.06.86 JP 94090/86**
**20.06.86 JP 94091/86**

(43) Date of publication of application:
**23.12.87 Bulletin 87/52**

(45) Publication of the grant of the patent:
**13.11.91 Bulletin 91/46**

(84) Designated Contracting States:
**BE DE FR GB IT NL**

(56) References cited:
**FR-A- 1 342 986**
**GB-A- 2 018 323**
**US-A- 4 384 449**

(73) Proprietor: **MITSUBISHI RAYON CO., LTD.**
**3-19, Kyobashi 2-chome Chuo-Ku**
**Tokyo 104(JP)**

(72) Inventor: **Togashi, Takahiko**
**1-60 Sunadabashi-4-chome Higashi-ku**
**Nagoya(JP)**
Inventor: **Kanamura, Tomotsugu**
**1-60 Sunadabashi-4-chome Higashi-ku**
**Nagoya(JP)**
Inventor: **Mori, Yoshiyuki**
**1-60 Sunadabashi-4-chome Higashi-ku**
**Nagoya(JP)**
Inventor: **Sato, Yoshinori**
**1-60 Sunadabashi-4-chome Higashi-ku**
**Nagoya(JP)**
Inventor: **Inoue, Yasuji**
**1-60 Sunadabashi-4-chome Higashi-ku**
**Nagoya(JP)**
Inventor: **Tsuchida, Teruhiro**
**1-60 Sunadabashi-4-chome Higashi-ku**
**Nagoya(JP)**

(74) Representative: **Lawrence, Peter Robin**
**Broughton et al**
**GILL JENNINGS & EVERY 53-64 Chancery**
**Lane**
**London WC2A 1HN(GB)**

Rank Xerox (UK) Business Services

## Description

This invention relates to conjugated yarn that contains metal and that combines textile properties (such as feel, appearance and colour) such that it is satisfactory in clothing with the property of providing electromagnetic interference (EMI) shielding.

It is known to provide EMI shielding using a cloth containing metal. Thus it is known to form a plating of a metal such as nickel or copper on the surface of cloth. See for instance Japanese Utility Model Unexamined Publication 61-64115. However the colour cannot be varied, the handling and appearance is not satisfactory for use in clothing, the product is expensive and the EMI shielding effect deteriorates with washing.

It is also known to form EMI shielding cloth from spun yarn into which short metal fibres are blended. However the ends of the metal fibres jut out from the yarn and give unpleasant feel.

It is also known (Japanese Utility Model Unexamined Publication 61-2407) to provide a conjugated yarn having a carbon fibre core and a sheath provided by winding gold leaf or silver leaf around the carbon fibre. However production is difficult as the metallic leaf is produced by evaporating metal on to a film-like substance and the final product has a rough and hard feel and so is not very suitable for use in clothing.

It would be desirable to provide a yarn that can combine good EMI shielding properties with satisfactory textile properties.

According to the invention a conjugated yarn is used, the yarn comprises a core and a sheath and contains metallic and non-metallic fibres and the core comprises a substantially continuous metal filament reinforced by non-metallic filament or yarn and the sheath comprises non-metallic filament or yarn that is wound around the core to provide at least 70% of the surface of the conjugated yarn and the non-metallic fibres are formed of chemical or synthetic fibres or natural fibres characterised in that the metallic filament of the core has a diameter of 50μm or less and the yarn is used for electromagnetic interference shielding.

US 4384449 relates to a yarn including a metallic wire strand or strands of diameter 100μm to 150μm for production of fabric having high mechanical strength. The fabric produced is used for example to make protective gloves especially adapted for use when handling sharp or pointed items.

The non-metallic filament or yarn in the core may be the same as the non-metallic filament or yarn in the sheath, or it may be different.

The or each non-metallic filament or yarn may be a yarn formed of natural fibres or of chemical or synthetic fibres or may be filaments of chemical or synthetic fibres. The natural, chemical or synthetic fibre components are chosen, especially in the sheath, to give the desired textile properties to the conjugated yarn. The non-metallic filament or yarn in the core reinforces the metallic filament.

The invention is illustrated in the accompanying drawings in which:-

Figure 1 is a perspective view of a conjugated yarn according to the invention formed by means of a hollow-spindle type twister;

Figure 2 is a perspective view of a conjugated yarn obtained by the method described in the example below;

Figure 3 is a perspective view of a cloth formed from the conjugated yarn of the invention.

In the drawings thin metal wire 1 and chemical or synthetic fibre or natural fibre yarn 2 provide a core and the sheath is provided by chemical or synthetic fibre or natural fibre yarn 3, or 3 and 3'. Typically the warp threads 4 and the weft threads 5 in a cloth according to the invention are both formed of the novel conjugated yarn.

The thin wire 1 is preferably of electrically conductive metal such as stainless steel or copper. Particularly good results are obtained when the thin wire is formed of flexible copper on to which polyurethane has been baked to improve rust prevention. The diameter of the wire should be below 50μm since at higher diameters the resultant yarn has low flexibility, is difficult to process, and cloth made from it tends to be rough and hard and to have inadequate recovery properties after deformation and inadequate draping properties. Preferably the diameter is from 20 to 30μm.

The thin metal wire is of low strength and so, if it was used alone, is liable to fracture and to cause unstable processing. By reinforcing it with non-metallic filament or yarn these difficulties are minimised and a satisfactory conjugated yarn can be provided. The wire preferably has an elongation of 15% or less. The described wire tends to have rather low recovery from elongation and so if the conjugated yarn is subjected to excessive elongation the metal wire may not recover from the elongation and may tend to protrude from the surface of the yarn. To minimise this difficulty the chemical or synthetic fibre or natural fibre yarn that is used in the invention, especially for forming the core, preferably has an elongation of 10% or less and most preferably 5% or less.

The wire normally has a boiling water shrinkage percentage of substantially zero. If the non-metallic

2

filament or yarn, especially the yarn in the core, has high boiling water shrinkage then again the wire tends to protrude from the yarn, with consequential damage to the feel of the cloth, because the yarn is often subjected to a heat treatment during dyeing or other process steps. Accordingly the chemical or synthetic fibre or natural fibre yarn, especially in the core, preferably has a boiling water shrinkage percentage of 5% or less, preferably 3% or less.

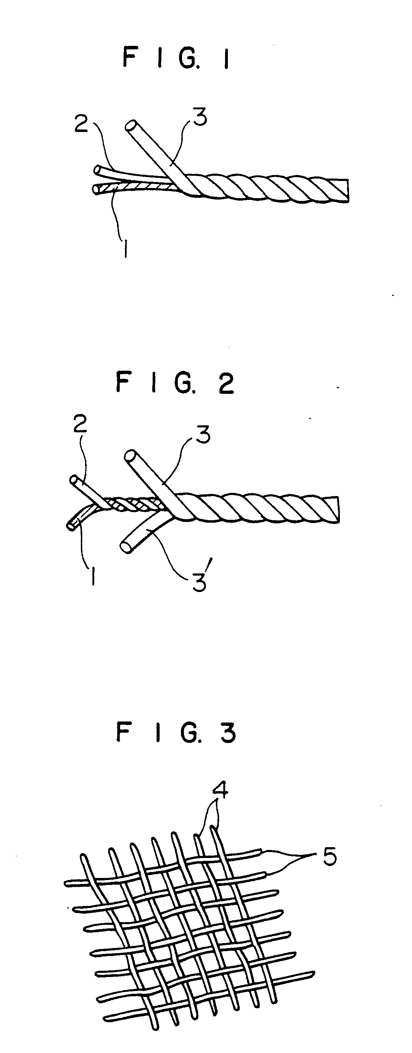

The wire I and the yarn 2 in the core may be in a doubled state and are preferably twisted together as shown in Figure 2 since the resultant conjugated yarn tends to be more stable against the problems discussed above.

The non-metallic filament or yarn that provides the sheath preferably provides at least 70%, and most preferably at least 90%, of the surface area of the conjugated yarn. By appropriate selection of the material of the non-metallic filament or yarn in the sheath it is possible to provide the conjugated yarn with conventional dyeing properties and so it is possible to produce the yarn, and the resultant cloth, to whatever colour is desired. Also the sheath imparts to the yarn a feel such that it is suitable for clothing.

The conjugated yarn can be produced in conventional manner, for instance by a ring twister having an overfeeding mechanism or by a hollow spindle type twister. The number of yarns used for producing the conjugated yarn may be one, two or more depending upon the properties that are required.

The conjugated yarn of the invention may be formed into a cloth. For optimum EMI shielding properties the yarn lengthwise and crosswise of the invention is the only yarn used for forming the cloth. Preferably the cloth is obtained by weaving the yarn at a density of 40 or more per inch, preferably 60 or more per inch (I5.7 per cm or 23.6 per cm). The EMI shielding effect increases as the density of the mesh structure increases and so reducing the diameter of the metal wire I is preferred.

The textile weave is not critical but best results for EMI shielding are obtained when the weave has a dense and uniform mesh structure and maximum number of nodes, such as plain weave, twill weave or satin weave. The cloth can be made by means of a conventional weaving machine such as a fly shuttle loom or rapier loom.

The properties of cloths obtained using conjugated yarn of the invention and having various textile weaves and densities are shown in the following table. In this A represents conjugated yarn of this invention produced according to the example described below.

B represents equal amounts of the conjugated yarn and a polyester filament yarn of 48 filaments and of I50 denier.

C represents polyester filament yarn of 48 filaments and of I50 denier.

| ◎ | excellent |
|---|---|
| o | good |
| Δ | somewhat inferior |
| x | inferior |

| Textile weave | Warp | Weft | Density (warp x weft) | Attenuation 1000 MHZ (dB) | Rating of effect |
|---|---|---|---|---|---|
| Plain weave | A | A | 80/inch x 80/inch | 45 | ◎ |
| | A | A | 60 x 60 | 36 | ◎ |
| | A | A | 40 x 40 | 30 | ○ |
| | A | A | 30 x 30 | 20 | △ |
| | B | B | 80 x 80 | 30 | ○ |
| | C | A | 80 x 80 | 3 | × |
| Twill weave | A | A | 80 x 80 | 38 | ◎ |
| Satin weave | A | A. | 80 x 80 | 36 | ◎ |

The conjugated yarn may be made as in the following example.

Example

A thin copper wire having a diameter of 24μm and a polyester filament yarn of 24 filaments and of 30 denier were doubled to provide the core portion. Two pieces of polyester filament false-twisted yarn of 36 filaments and of 75 denier were used as sheath portion. This was applied by twisting under the conditions described below to obtain thin-metal-wire conjugated yarn having a coating percentage of about 90% and a sufficient flexibility.

4

The conjugated yarn was made into a cloth having plain weave having warp and weft densities of 80/inch (3l.5/cm) each. The cloth had good processability and dyeability, had sufficient feeling and appearance for clothing, and was excellent in EMI shielding function.

| Twister: | a ring twister |
|---|---|
| Rotation rate: | 7,200 rpm |
| Number of twist: | 400 t/m |
| Tension of yarn in the core portion | 35g |
| Overfeeding percentage of yarn in the sheath portion | 4% |

Thus the invention provides yarn that can be formed into cloth giving good EMI shielding properties and which can have attractive clothing properties such as colour, appearance, feeling and durability. The cloth can be used in clothing, especially working clothing or uniforms or white robes, or as curtains, wall materials or other EMI coverings.

## Claims

1. Use of a conjugated yarn having a core and a sheath and containing metallic and non-metallic fibres and in which the core comprises substantially continuous metallic filament reinforced by non-metallic filament or yarn and the sheath comprises non-metallic filament or yarn that is wound around the core and provides at least 70% of the surface area of the conjugated yarn and the non-metallic fibres are formed of chemical or synthetic fibres or natural fibres characterised in that the metallic filament of the core has a diameter of 50µm or less and the yarn is used for electromagnetic interference shielding.

2. Use of a yarn according to claim 1 in which the metallic filament is formed of copper and has a coating of polyurethane baked on to it.

3. Use of a yarn according to claim 1 or claim 2 in which the metallic filament has an elongation of 15% or less.

4. Use of a yarn according to any preceding claim in which the non-metallic filament or yarn in the core has an elongation of 10% or less.

5. Use of a yarn according to any preceding claim in which the non-metallic filament or yarn in the core has a boiling water shrinkage of 5% or less.

6. Use of a yarn according to any preceding claim in which the core is a twisted yarn.

7. Use of cloth formed from yarn according to any preceding claim for electromagnetic interference shielding.

## Revendications

1. Utilisation d'un fil composite comportant un noyau et une gaine et contenant des fibres métalliques et non métalliques, et dans lequel le noyau comprend un filament métallique sensiblement continu renforcé par un filament ou un fil non métallique, et la gaine comprend un filament ou un fil non métallique qui est enroulé autour du noyau et constitue au moins 70 % de la surface du fil composite, et les fibres non métalliques sont formées de fibres chimiques ou synthétiques ou de fibres naturelles, ce fil étant caractérisé en ce que le filament métallique du noyau est d'un diamètre de 50 µm ou moins, et que le fil est utilisé comme protection contre les interférences électromagnétiques.

2. Utilisation d'un fil selon la revendication 1, dans lequel le filament métallique est en cuivre et possède un revêtement de polyuréthanne cuit sur lui.

3. Utilisation d'un fil selon la revendication 1 ou la revendication 2, dans lequel l'allongement du filament métallique est de 15 % ou moins.

4. Utilisation d'un fil selon l'une des revendications précédentes, dans lequel l'allongement du filament ou fil non métallique du noyau est de 10 % ou moins.

5. Utilisation d'un fil selon l'une des revendications précédentes, dans lequel le rétrécissement à l'eau bouillante du filament ou fil non métallique est de 5 % ou moins.

6. Utilisation d'un fil selon l'une des revendications précédentes, dans lequel le noyau est un fil retors.

7. Utilisation d'une étoffe formée à partir de fil selon l'une des revendications précédentes, en vue d'une protection contre les interférences électromagnétiques.

## Patentansprüche

1. Verwendung eines Verbundgarnes mit einem Kern und einer Umhüllung, umfassend metallische und nicht-metallische Fasern, wobei der Kern im wesentlichen ein kontinuierliches metallisches Filament, verstärkt durch nicht-metallisches Filament oder Garn, enthält und die Umhüllung ein nicht-metalisches Filament oder Garn enthält, welches um den Kern gewunden ist und mindestens 70 % der Mantelfläche des Verbundgarnes ausmacht, wobei die nicht-metallischen Fasern aus chemischen oder synthetischen Fasern oder Naturfasern gebildet sind, dadurch **gekennzeichnet,** dass das metallische Filament des Kernes einen Durchmesser von 50 µm oder weniger hat und das Garn für elektromagnetische Abschirmung verwendet wird.

2. Verwendung eines Garnes nach Anspruch 1, bei dem das metallische Filament aus Kupfer gebildet ist und ein Polyurethanüberzug durch Ofentrocknen darauf angebracht ist.

3. Verwendung eines Garnes nach Anspruch 1 oder Anspruch 2, bei dem das metallische Filament eine Dehnung von 15 % oder weniger hat.

4. Verwendung eines Garnes nach einem der vorhergehenden Ansprüche, bei dem das nicht-metallische Filament oder Garn in dem Kern eine Dehnung von 10 % oder weniger hat.

5. Verwendung eines Garnes nach einem der vorhergehenden Ansprüche, bei dem das nicht-metallische Filament oder Garn in dem Kern eine Kochwasserschrumpfung von 5 % oder weniger hat.

6. Verwendung eines Garnes nach einem der vorhergehenden Ansprüche, bei dem der Kern ein gewundenes Garn ist.

7. Verwendung eines Tuches, gebildet aus Garn nach einem der vorhergehenden Ansprüche, für die elektromagnetische Abschirmung.

EP 0 250 260 B1

# F I G. 1

# F I G. 2

# F I G. 3